# EUROPÄISCHE PATENTANMELDUNG

(11) **EP 2 623 992 A1**
(43) Veröffentlichungstag der Anmeldung: **07.08.2013**
(21) Anmeldenummer: 12153824.3
(22) Anmeldetag: 03.02.2012
(51) Int. Cl.: G01P 3/00, G01P 3/487, G01P 3/488, G01D 5/244, H03K 21/40, H01L 41/113

(54) **Drehgeber und Verfahren zu dessen Betrieb**

(71) Anmelder: Siemens Aktiengesellschaft, 80333 München (DE)
(72) Erfinder: Wetzel, Ulrich, 91325 Adelsdorf (DE)

(57) **Zusammenfassung**

Die Erfindung betrifft einen Drehgeber (32) zur Erfassung einer Anzahl von Umdrehungen einer rotierenden Einheit, wobei als Sensor ein energieautarker Sensor (24) fungiert, mit dem bei einer bestimmten Rotationslage ein Sensorsignal (26) generierbar ist, aufgrund dessen der Inhalt einer Speicherzelle in einem Speicher (30) beeinflussbar ist, wobei als energieautarker Sensor (24) ein piezoelektrischer Wandler (18) fungiert, der durch eine Auslenkung eines ferromagnetischen Körpers (20) aktivierbar ist. Ein Magnet (14) auf dem rotierenden Körper wirkt auf den ferromagnetischen Körper (20), welcher am freien Ende eines Biegebalkens angebracht ist, welcher durch das piezoelektrische Element (18)gebildet wird.

## Beschreibung

Die Erfindung betrifft einen Drehgeber zur Erfassung einer Anzahl von Umdrehungen einer rotierenden Einheit, also zum Beispiel einer Motorwelle oder dergleichen. Die Erfindung betrifft des Weiteren ein Verfahren zum Betrieb eines solchen Drehgebers.

Solche Drehgeber (Encoder) sind an sich bekannte Messsysteme, bei denen man grundsätzlich zwischen sogenannten Singleturn-Gebern und Muliturn-Gebern unterscheidet. Sie unterscheiden sich dadurch, dass ein Multiturn-Geber zusätzlich zur Winkellage auch die Umdrehungen der jeweiligen rotierenden Einheit, also zum Beispiel der Achse, zählen kann.

Heutige Multiturn-Geber werden entweder durch ein mehrstufiges Getriebe, das optisch oder magnetisch abgetastet wird, durch Sensoreinheiten mit Energiespeicher (Batterie oder Akkumulator) oder Sensoreinheiten mit kleinen Generatoren realisiert. In jedem Fall muss gewährleistet sein, dass die Anzahl der Rotationen der jeweiligen rotierenden Einheit sicher erfasst werden kann. Die bedeutet aber auch, dass bei einem eventuellen Spannungsausfall die Erfassungsfunktionalität weiter gewährleistet sein muss.

Alle derzeitigen Varianten haben einige Nachteile, wobei bei einer Batterielösung speziell eine stark begrenzte Lebensdauer, besonders bei hohen Temperaturen, und der sich aufgrund der erforderlichen Wartung ergebende zusätzliche Aufwand zu nennen sind. Eine Lösung mit einem mehrstufigen Getriebe ist demgegenüber relativ teuer und aufgrund von Verschleiß, speziell bei sehr hohen Drehzahlen und/oder sehr hohen Temperaturen, ergibt sich ebenfalls eine Einschränkung der Lebensdauer. Eine Lösung mit einem mechnisch-elektrischen Energiewandler, also einem Impulsgenergerator, ist aufgrund der realtiv hohen Energieverluste für die elektronische Speicherung der Lageinformation und der mechanischer Reibung an den bewegten Teilen sehr aufwendig. Dabei erhöhen sich diese Verluste mit steigender Temperatur.

In hochwertigen optischen Multiturn-Gebern kommen derzeit vorwiegend Getriebelösungen zum Einsatz. Alle damit verbundenen Probleme wie hoher Preis, Beschränkung in Drehzahl und Temperatur, müssen in Kauf genommen werden. Außerhalb der zulässigen Betriebsparameter ist ein Einsatz nicht möglich. Neuartige Lösungen auf diesem Gebiet sind Kombinationen aus Sensoren und Energiewandlern. Dabei kommen zwei Varianten solcher Energiewandler zum Einsatz: Ein erstes Prinzip basiert auf einer Spule mit einem gewickelten Wiganddraht, die durch einen an der Drehachse befestigten Magneten angeregt wird. Ein zweites Prinzip basiert auf einer Blattfeder im Zentrum einer Spule, die ebenfalls durch einen an der Drehachse befestigten Magneten angeregt wird. Beide Varianten sind trotz ihres vergleichsweise kompakten Aufbaus aufgrund des erforderlichen mechanischen Aufwands noch relativ teuer, so dass häufig eher auf eine Batterielösung zurückgegriffen wird.

Eine Aufgabe der vorliegenden Erfindung besteht entsprechend darin, einen Drehgeber zur Erfassung einer Anzahl von Umdrehungen einer rotierenden Einheit anzugeben, die unabhängig von einer externen Spannungsquelle ist und damit auch bei Spannungsausfall sicher arbeitet und gleichzeitig kompakt und preiswert ist.

Diese Aufgabe wird erfindungsgemäß mit einem Drehgeber in Form eines Multiturn-Gebers oder Multigebers mit den Merkmalen des Anspruchs 1 gelöst. Dabei ist bei einem Drehgeber zur Erfassung einer Anzahl von Umdrehungen einer rotierenden Einheit, wobei als Sensor ein energieautarker Sensor (Sensor mit einem Energiewandler) fungiert, mit dem bei einer bestimmten Rotationslage ein Sensorsignal generierbar ist, aufgrund dessen der Inhalt einer Speicherzelle in einem Speicher beeinflussbar ist, vorgesehen, dass als energieautarker Sensor ein piezoelektrischer Wandler fungiert, der durch eine Auslenkung eines ferromagnetischen Körpers, also zum Beispiel eines Eisenkörpers oder dergleichen, aktivierbar ist.

Der Vorteil der Erfindung besteht darin, dass aufgrund der Ausführung des Sensors als energieautarker Sensor, nämlich hier in Form eines piezoelektrischen Wandlers, die Erfassung der Umdrehungsanzahl auch bei Situationen erhalten bleibt, bei dem eine ansonsten zur Energieversorgung des Drehgebers verwendbare externe Spannungsquelle ausfällt. Jedes Mal, wenn der Sensor aufgrund einer Auslenkung des ferromagnetischen Körpers aktiviert wird, ergibt sich eine mechanische Verformung des piezoelektrischen Wandlers. Aufgrund dieser Verformung ist ein Sensorsignal generierbar, mit dem der Inhalt einer Speicherzelle beeinflussbar, also zum Beispiel inkrementierbar oder dekrementierbar, ist.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin; sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Bei einer besonderen Ausführungsform des Drehgebers ist vorgesehen, dass als Sensorsignal ein Spannungsimpuls generierbar ist oder generiert wird, mit dem eine Logikeinheit kurzfristig aktivierbar ist oder aktiviert wird und wobei mittels der Logikeinheit die Beeinflussung der Speicherzelle erfolgt. Die Verwendung einer solchen Logikeinheit hat den Vorteil, dass der Inhalt der jeweiligen Speicherzelle gezielt zum Beispiel inkrementiert oder dekrementiert werden kann, so dass bei der Beeinflussung des Inhalts der Speicherzelle gezielt deren bisheriger Inhalt berücksichtig wird. Ansonsten besteht, wenn mit einem Sensorsignal direkt eine zum Beispiel durch eine Kippstufe realisierte Speicherzelle beeinflusst wird, die Möglichkeit, anhand von Zustandsänderungen der Speicherzelle auf aufeinander folgende Vollumdrehungen der jeweiligen rotierenden Einheit zu schließen. Selbst wenn eine solche Kippstufe als kaskadierte Kippstufe ausgeführt ist, um mehrere Rotationen zu erfassen, besteht der Vorteil der Verwendung einer kurzfristig durch einen vom piezoelektrischen Wandler generierten Spannungsimpuls aktivierbaren Logikeinheit darin, dass mit der Logikeinheit die Positionsinformation in einen nicht-flüchtigen Speicher, in dem die Speicherzelle realisiert ist, eingetragen werden kann, aus dem später, auch wenn zwischenzeitlich die Spannung ausfällt, die Positionsinformation wieder abgerufen werden kann.

Bei einer Ausführungsform des Drehgebers kommt in Betracht, dass ein Magnet, der zur Auslenkung des piezoelektrischen Wandlers vorgesehen ist, an der rotierenden Einheit oder an einer mit der rotierenden Einheit rotierenden Scheibe angebracht ist. Die Verwendung einer mit der rotierenden Einheit, also zum Beispiel einer Motorachse oder dergleichen, rotierenden Scheibe hat den Vorteil, dass der Magnet beabstandet von der Drehachse der jeweiligen rotierenden Einheit positionierbar ist, so dass für eine Dimensionierung des piezoelektrischen Wandlers, der im Betrieb durch eine Auslenkung eines ferromagnetischen Körpers aktivierbar ist, ein entsprechender Raum zur Verfügung steht und der piezoelektrische Wandler damit eine Ausdehnung erfahren kann, wie sie zur Erzeugung eines Sensorsignals, insbesondere eines zur Erzeugung eines Spannungsimpulses für eine Versorgung einer Logikeinheit ausreichenden Sensorsignals notwendig ist.

Bei einer Ausführungsform des piezoelektrischen Wandlers ist dieser als piezoelektrischer Flächenwandler realisiert und ist an einer Seite mit einem Abstandsstück an einem Bauelementeträger oder dergleichen angebracht, wobei sich der ferromagnetische Körper an einer der Seite mit dem Abstandsstück gegenüberliegenden, freien Seite befindet. Der piezoelektrische Flächenwandler ist damit einseitig mit dem Abstandsstück fixiert und das gegenüberliegende Ende mit dem ferromagnetischen Körper ist frei beweglich, so dass speziell eine Verformung des Flächenwandlers möglich ist, wenn der ferromagnetische Körper in das Magnetfeld des rotierenden Magneten eintritt. Diese Verformung bewirkt das Sensorsignal bzw. den Spannungsimpuls.

Die Position des rotierenden Magneten und des ferromagnetischen Körpers und damit die Ausrichtung des piezoelektrischen Wandlers sind so aufeinander abgestimmt, dass sich der ferromagnetische Körper des energieautarken Sensors im Betrieb über einer Bewegungsbahn des rotierenden Magneten befindet.

Eine besondere Ausführungsform des Drehgebers wie hier und nachfolgend beschrieben zeichnet sich dadurch aus, dass dieser eine Mehrzahl energieautarker Sensoren, wie sie ebenfalls hier und nachfolgend beschrieben sind, umfasst. Wenn mit einem derartigen energieautarken Sensor jeweils Vollumdrehungen der rotierenden Einheit erfassbar sind, können mit zum Beispiel zwei oder vier äquidistant angeordneten energieautarken Sensoren auch Halbumdrehungen oder Viertelumdrehungen der jeweils rotierenden Einheit erfasst werden. Die Anzahl der energieautarken Sensoren kann grundsätzlich beliebig erhöht werden, um eine noch feingranularere Positionserfassung zu ermöglichen.

Eine weitere besondere Ausführungsform eines Drehgebers zeichnet sich durch eine Zusammenfassung von genau drei energieautarken Sensoren wie hier und nachfolgend beschrieben aus. Mit drei derartigen Sensoren und den im Betrieb in die jeweiligen Speicherzellen geschriebenen Positionsinformationen lässt sich nämlich die Drehrichtung der jeweils rotierenden Einheit erfassen, wenn die Reihenfolge, in der sich die Speicherinhalte der jeweiligen Speicherzellen verändern, analysiert wird.

Im Hinblick auf eine möglichst kompakte Ausführung des Drehgebers ist vorgesehen, dass der oder jeder energieautarke Sensor zusammen mit einer Logikeinheit zur Verarbeitung von Sensorsignalen von dem oder jedem Sensor und zusammen mit einem nicht-flüchtigen Speicher in einem miniaturisierten, elektromechanischen Bauteil integriert sind. Das Bauteil umfasst dann alle Funktionseinheiten des Drehgebers und zumindest geeignete Anschlüsse zum Auslesen des Inhalts des Speichers, gegebenenfalls auch Anschlüsse zum Initialisieren des Drehgebers, insbesondere zum Initialisieren des Speicherinhalts. Bei einer besonderen Ausführungsform eines solchen miniaturisierten elektromechanischen Bauteils ist der oder jeder energieautarke Sensor als Mikrosystem (piezoelektrisches MEMS) ausgeführt, so dass das miniaturisierte elektromechanische Bauteil den oder jeden energieautarken Sensor in Form eines solchen Mikrosystems umfasst. Zum Anschluss eines solchen Bauteils werden nur die Anschlüsse zum Auslesen des Inhalts des Speichers und eventuell Anschlüsse zum Initialisieren des Drehgebers benötigt. Eine Spannungsversorgung oder dergleichen ist unnötig. Der Drehgeber lässt sich damit auch in schwierigen Einbausituationen verwenden. Ansonsten kommt anstelle der hier als Bauelementeträger des Drehgebers beschriebenen Struktur auch eine Leiterplatte oder dergleichen in Betracht, die eine Steuerungs- und/oder Überwachungshardware für zum Beispiel einen Elektromotor umfasst, so dass das Bauteil unmittelbar in solche Schaltungen integrierbar ist. Auch in einer solchen Situation reichen die Anschlüsse zum Zugriff auf den Speicher aus und die Anzahl der erfassten Umdrehungen kann durch die Steuerungs- oder Überwachungshardware auch nach einem Spannungsausfall ausgelesen werden.

Bei einem Verfahren zum Betrieb eines Drehgebers wie hier und nachfolgend beschrieben, bei dem der energieautarke Sensor bei einer bestimmten Rotationslage ein Sensorsignal generiert, wird aufgrund des Sensorsignals, gegebenenfalls eines mit dem Sensorsignal erzeugten Spannungsimpulses, der Inhalt einer Speicherzelle in einem Speicher beeinflusst, also zum Beispiel inkrementiert oder dekrementiert. Bei einem Verfahren zum Betrieb eines Drehgebers mit genau drei energieautarken Sensoren wird aus einer Reihenfolge, in der die jeweils einem energieautarken Sensor zugeordneten Speicherzellen beeinflusst werden, eine Drehrichtung der rotierenden Einheit abgeleitet.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen. Das oder jedes Ausführungsbeispiel ist nicht als Einschränkung der Erfindung zu verstehen. Vielmehr sind im Rahmen der vorliegenden Offenbarung Abänderungen und Modifikationen möglich, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen bzw. Elementen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen.

Es zeigen
- FIG 1: einen Drehgeber mit einem energieautarken Sensor, wobei die erzeugte Energie für die Beeinflussung einer Speicherzelle vorgesehen ist,
- FIG 2: den Drehgeber gemäß FIG 1 in einer Seitenansicht,
- FIG 3: den Drehgeber gemäß FIG 1 und FIG 2 in einer Ansicht von oben und
- FIG 4: eine spezielle Ausführungsform eines Drehgebers nach dem in FIG 1 bis FIG 3 dargestellten Prinzip und mit einer Mehrzahl energieautarker Sensoren.

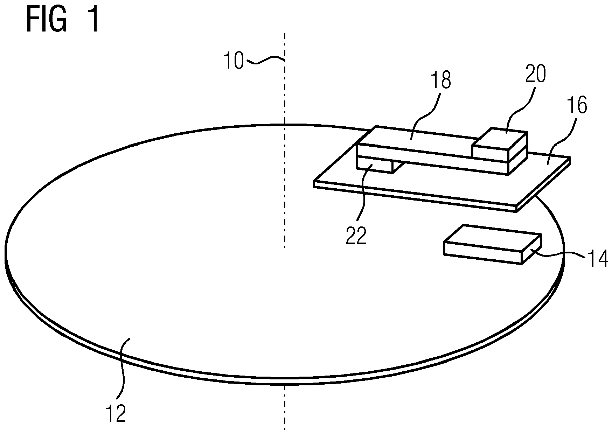

FIG 1 zeigt in schematisch vereinfachter Darstellung eine um eine Drehachse 10 rotierende Scheibe 12. Bei der Drehachse 10 handelt es sich um die Drehachse 10 derjenigen Einheit, deren Umdrehungen zu erfassen sind. Als Beispiel für eine solche Einheit kann eine Achse eines Antriebs oder Elektromotors genannt werden. Die Scheibe 12 ist optional und grundsätzlich kann anstelle der mit der jeweiligen rotierenden Einheit ebenfalls rotierenden Scheibe 12 ein an dieser angeordneter Magnet 14 auch an der rotierenden Einheit, also zum Beispiel einer Achse, selbst angebracht sein. Die Beschreibung wird auf Basis der Darstellung in FIG 1 und entsprechend unter der Annahme einer mit der rotierenden Einheit rotierenden Scheibe 12 und eines dort befindlichen Magneten 14 fortgesetzt.

Ober- oder unterhalb der Scheibe 12, zumindest ober- oder unterhalb der Bewegungsbahn des Magneten 14, befindet sich ein Bauelementeträger 16. Auf diesem ist ein energieautarker Sensor (Sensor mit Energiewandler) angeordnet, mit dem bei einer bestimmten Rotationslage der Scheibe 12 ein Sensorsignal generierbar ist. Als energieautarker Sensor fungiert dabei ein piezoelektrischer Wandler 18, der durch eine Auslenkung eines ferromagnetischen Körpers 20, also zum Beispiel eines Eisenkörpers, aktivierbar ist. Die Position von ferromagnetischem Körper 20 als Element des energieautarken Sensors einerseits und Magnet 14 auf der Scheibe 12 oder direkt an der rotierenden Einheit andererseits ist grundsätzlich austauschbar, so dass sich auf der Scheibe 12 anstelle des Magneten 14 auch ein ferromagnetischer Körper 20 und entsprechend am piezoelektrischen Wandler 18 auch ein Magnet 14 befinden kann.

Der piezoelektrische Wandler 18 ist bei der dargestellten Ausführungsform als piezoelektrischer Flächenwandler ausgeführt und an einer Seite mit einem Abstandsstück 22 an dem Bauelementeträger 16 angebracht. Das andere Ende des piezoelektrischen Wandlers 18 ist frei und an diesem, der Seite mit dem Abstandsstück 22 gegenüberliegenden, freien Ende befindet sich der ferromagnetische Körper 20, oder - bei der oben skizzierten funktionalen Umkehr - der Magnet 14. Die weitere Beschreibung wird auf Basis der Darstellung in FIG 1, nämlich einem an der Scheibe 12 angebrachten Magnet 14 und einem am piezoelektrischen Wandler 18 angebrachten ferromagnetischen Körper 20 fortgesetzt.

Der energieautarke Sensor ist mit seinem ferromagnetischen Körper 20 so angeordnet und ausgerichtet, dass sich der ferromagnetische Körper 20 im Betrieb des Drehgebers über einer Bewegungsbahn des rotierenden Magneten 14 befindet. Jedes Mal, wenn bei einer Umdrehung der Scheibe 12 der Magnet 14 in den Bereich des Drehgebers kommt, der ferromagnetische Körper 20 also vom Magnetfeld des Magneten 14 erfasst wird, resultiert eine mechanische Verformung des piezoelektrischen Wandlers 18 aufgrund der magnetischen Anziehung des ferromagnetischen Körpers 20 durch den Magneten 14.

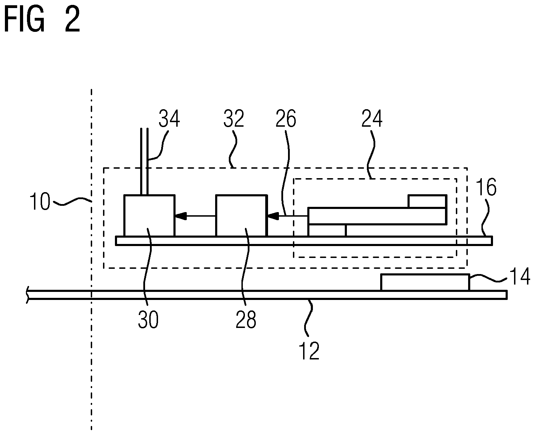

FIG 2 zeigt die Situation gemäß FIG 1 in einer schematisch vereinfachten Seitenansicht, wobei die Scheibe 12 nur noch teilweise dargestellt ist. Im Weiteren werden der piezoelektrische Wandler 18, der an dessen freiem Ende befindliche ferromagnetische Körper 20 und das Abstandsstück 22 als energieautarker Sensor (Sensor mit Energiewandler) 24 bezeichnet. Dieser erzeugt bei einer mechanischen Auslenkung des piezoelektrischen Wandlers 18 ein Sensorsignal 26, das zum Beispiel über eine entsprechende, nicht dargestellte Leiterbahn auf dem Bauelementeträger 16 geführt wird. Das Sensorsignal 26 wird zu einer Logikeinheit 28 geführt, wo ein als Sensorsignal 26 generierter Spannungsimpuls für eine kurzzeitige Aktivierung der Logikeinheit 28 sorgt. Die so aktivierte Logikeinheit 28 bewirkt eine Beeinflussung eines Inhalts einer Speicherzelle in einem Speicher 30 aufgrund des Sensorsignals 26. Als Speicher 30 kommt dabei speziell ein nicht-flüchtiger Speicher (NV-RAM) in Betracht. Der Speicher 30 kann auch von der Logikeinheit 28 umfasst sein.

Eine Gesamtheit aus dem energieautarken Sensor 24, der Logikeinheit 28 und dem Speicher 30 wird im Folgenden als Drehgeber 32 bezeichnet. Der Drehgeber 32 weist zum Auslesen des Inhalts des Speichers 30 entsprechende Kontaktelemente 34 auf.

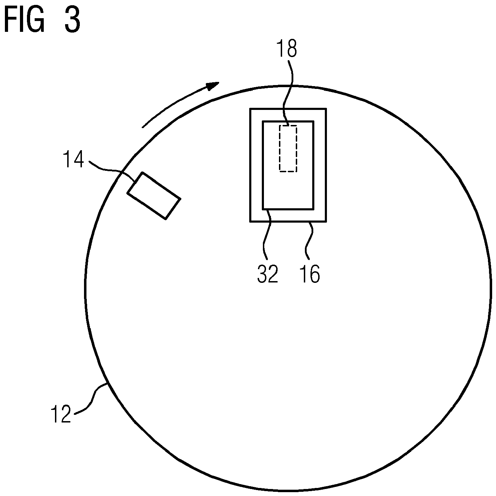

FIG 3 zeigt zur Verdeutlichung einer Betriebssituation des Drehgebers 32 eine Darstellung der Verhältnisse gemäß FIG 1 und FIG 2 in einer Ansicht von oben. Erkennbar ist die rotierende Scheibe 12 mit dem darauf angebrachten Magneten 14. Die Rotation ist durch eine hier willkürlich angenommene Rotationsrichtung im Uhrzeigersinn mit einem entsprechenden Pfeil verdeutlicht. Bei einer Rotation der Scheibe 12 passiert der Magnet 14 bei jeder Vollumdrehung der Scheibe 12 den Drehgeber 32, der - wie bereits erläutert - auf einem Bauelementeträger 16 über einer Bewegungsbahn des rotierenden Magneten 14 angeordnet ist. Speziell befindet sich der piezoelektrische Wandler 18 des Drehgebers 32 im Bereich dieser Bewegungsbahn, so dass der damit gebildete energieautarke Sensor 24 bei einer Auslenkung des am freien Ende des piezoelektrischen Wandlers 18 befindlichen ferromagnetischen Körpers 20 aktivierbar ist.

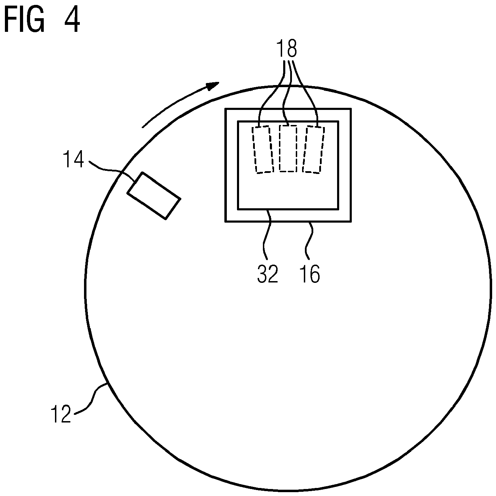

FIG 4 zeigt abschließend eine spezielle Ausführungsform eines Drehgebers 32 mit einer Mehrzahl energieautarker Sensoren 24, von denen jeweils nur der piezoelektrische Wandler 18 gezeigt ist. Mit genau drei solchen Sensoren 24 kann aus einer Reihenfolge, in der die jeweils einem Sensor 24 zugeordneten Speicherzellen beeinflusst, also zum Beispiel inkrementiert oder dekrementiert, werden, eine Drehrichtung der jeweiligen rotierenden Einheit, also zum Beispiel der Scheibe 12, abgeleitet werden.

Nicht dargestellt ist die Möglichkeit, dass der oder jeder energieautarke Sensor 24 zusammen mit der Logikeinheit 28 zur Verarbeitung von Sensorsignalen 26 von dem oder jedem Sensor 24 und zusammen mit einem nicht-flüchtigen Speicher 30 in einem miniaturisierten, elektromechanischen Bauteil integriert ist. Allerdings kann der insoweit in den Figuren durch den die jeweiligen Funktionseinheiten umfassenden Rahmen dargestellte Drehgeber mit seinem Rahmen als schematisch vereinfachte Darstellung eines Volumens eines solchen miniaturisierten Bauteils angesehen werden. Von einem solchen Bauteil kann der oder jeder energieautarke Sensor 24 als Mikrosystem (MEMS) umfasst sein.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier vorgelegten Beschreibung lassen sich damit kurz wie folgt zusammenfassen: Angegeben werden ein Drehgeber 32 zur Erfassung einer Anzahl von Umdrehungen einer rotierenden Einheit und ein Verfahren zum Betrieb eines solchen Drehgebers 32, wobei als Sensor ein energieautarker Sensor 24 fungiert, mit dem bei einer bestimmten Rotationslage ein Sensorsignal 26 generierbar ist, aufgrund dessen der Inhalt einer Speicherzelle in einem Speicher 30 beeinflussbar ist, wobei als energieautarker Sensor 24 ein piezoelektrischer Wandler 18 fungiert, der durch eine Auslenkung eines ferromagnetischen Körpers 20 aktivierbar ist. Soweit das Betriebsverfahren betroffen ist, zeichnet sich dieses dadurch aus, dass der energieautarke Sensor 24 bei einer bestimmten Rotationslage ein Sensorsignal 26 generiert, aufgrund dessen der Inhalt einer Speicherzelle in einem Speicher 30 beeinflusst wird, insbesondere inkrementiert oder dekrementiert wird. Das Sensorsignal 26 kann dabei als Spannungsimpuls zur zumindest kurzfristigen Aktivierung einer Logikeinheit 28 dienen, so dass eine gezielte Beeinflussung des Inhalts der Speicherzelle mittels der Logikeinheit 28 erfolgen kann.

## Patentansprüche

1. Drehgeber zur Erfassung einer Anzahl von Umdrehungen einer rotierenden Einheit, wobei als Sensor ein energieautarker Sensor (24) fungiert, mit dem bei einer bestimmten Rotationslage ein Sensorsignal (26) generierbar ist, aufgrund dessen der Inhalt einer Speicherzelle in einem Speicher (30) beeinflussbar ist,
**dadurch gekennzeichnet, dass** als energieautarker Sensor (24) ein piezoelektrischer Wandler (18) fungiert, der durch eine Auslenkung eines ferromagnetischen Körpers (20) aktivierbar ist.

2. Drehgeber nach Anspruch 1, wobei als Sensorsignal (26) ein Spannungsimpuls generierbar ist, mit dem eine Logikeinheit (28) kurzfristig aktivierbar ist, und wobei mittels der Logikeinheit (28) die Beeinflussung der Speicherzelle bewirkbar ist.

3. Drehgeber nach Anspruch 1 oder 2, mit einem an der rotierenden Einheit oder an einer mit der rotierenden Einheit rotierenden Scheibe (12) angebrachten Magnet (14).

4. Drehgeber nach Anspruch 1, 2 oder 3, wobei der piezoelektrischen Wandler (18) als piezoelektrischer Flächenwandler ausgeführt und an einer Seite mit einem Abstandsstück (22) an einem Bauelementeträger (16) angebracht ist, wobei sich an einer der Seite mit dem Abstandsstück (22) gegenüberliegenden, freien Seite der ferromagnetische Körper (20) befindet.

5. Drehgeber nach Anspruch 4, wobei sich der ferromagnetische Körper (20) des energieautarken Sensors (24) im Betrieb über einer Bewegungsbahn des rotierenden Magneten (14) befindet.

6. Drehgeber nach einem der vorangehenden Ansprüche mit einer Mehrzahl energieautarker Sensoren (24).

7. Drehgeber nach Anspruch 6 mit genau drei energieautarken Sensoren (24).

8. Drehgeber nach einem der vorangehenden Ansprüche, wobei der oder jeder energieautarke Sensor (24) zusammen mit einer Logikeinheit (28) zur Verarbeitung von Sensorsignalen (26) von dem oder jedem Sensor (24) und zusammen mit einem nicht-flüchtigen Speicher (30) in einem miniaturisierten, elektromechanischen Bauteil integriert sind.

9. Drehgeber nach Anspruch 8, wobei das miniaturisierte, elektromechanische Bauteil den oder jeden energieautarken Sensor (24) als Mikrosystem umfasst.

10. Verfahren zum Betrieb eines Drehgebers nach einem der vorangehenden Ansprüche, wobei der energieautarke Sensor (24) bei einer bestimmten Rotationslage ein Sensorsignal (26) generiert, aufgrund dessen der Inhalt einer Speicherzelle in einem Speicher (30) beeinflusst wird, insbesondere inkrementiert oder dekrementiert wird.

11. Verfahren zum Betrieb eines Drehgebers nach Anspruch 6, wobei aus einer Reihenfolge, in der die jeweils einem energieautarken Sensor (24) zugeordneten Speicherzellen beeinflusst werden, eine Drehrichtung der rotierenden Einheit abgeleitet wird.
